# EUROPÄISCHE PATENTSCHRIFT

(11) **EP 2 474 049 B1**
(45) Veröffentlichungstag und Bekanntmachung des Hinweises auf die Patenterteilung: **21.12.2016**
(21) Anmeldenummer: 10754254.0
(22) Anmeldetag: 06.08.2010
(51) Int. Cl.: H01L 23/00, H01L 33/44, H01L 25/075, H01L 33/62, H01L 33/50

(54) **OPTOELEKTRONISCHES MODUL AUFWEISEND ZUMINDEST EINEN ERSTEN HALBLEITERKÖRPER MIT EINER STRAHLUNGSAUSTRITTSSEITE UND EINER ISOLATIONSSCHICHT UND VERFAHREN ZU DESSEN HERSTELLUNG**
OPTOELECTRONIC MODULE COMPRISING AT LEAST ONE FIRST SEMICONDUCTOR BODY HAVING A RADIATION OUTLET SIDE AND AN INSULATION LAYER AND METHOD FOR THE PRODUCTION THEREOF
MODULE OPTOÉLECTRONIQUE PRÉSENTANT AU MOINS UN PREMIER CORPS SEMI-CONDUCTEUR COMPORTANT UN CÔTÉ SORTIE DU RAYONNEMENT ET UNE COUCHE ISOLANTE, ET PROCÉDÉ DE FABRICATION DUDIT MODULE

(30) Priorität: 03.09.2009 DE 102009039891
(43) Veröffentlichungstag der Anmeldung: 11.07.2012
(73) Patentinhaber: OSRAM Opto Semiconductors GmbH, 93055 Regensburg (DE)
(72) Erfinder: WEIDNER, Karl, 81245 München (DE); WIRTH, Ralph, 93138 Lappersdorf (DE); KALTENBACHER, Axel, 93098 Mintraching (DE); WEGLEITER, Walter, 93152 Nittendorf (DE); BARCHMANN, Bernd, Regensburg 93059 (DE); WUTZ, Oliver, 93049 Regensburg (DE); MARFELD, Jan, 93055 Regensburg (DE)
(74) Vertreter: Epping - Hermann - Fischer
(86) Internationale Anmeldenummer: PCT/DE2010/000944
(87) Internationale Veröffentlichungsnummer: WO 2011/026456

(56) Entgegenhaltungen:
- WO-A2-2007/025521
- DE-A1-102007 021 009
- DE-A1-102007 043 001
- DE-A1-102008 005 497

## Beschreibung

Die vorliegende Erfindung betrifft ein optoelektronisches Modul aufweisend zumindest einen ersten Halbleiterkörper mit einer Strahlungsaustrittsseite, einer Isolationsschicht und einer planaren Leitstruktur zur planaren Kontaktierung des Halbleiterkörpers. Weiterhin betrifft die Erfindung ein Verfahren zum Herstellen eines optoelektronischen Moduls.

Ein Bauelement mit einem Halbleiterkörper, der planar kontaktiert ist, ist beispielsweise aus der Druckschrift DE 103 53 679 A1 bekannt. Insbesondere weist das Bauelement ein Substrat, einen darauf angeordneten, optoelektronischen Halbleiterkörper und eine Isolationsschicht auf, wobei die Isolationsschicht über das Substrat und dem optoelektronischen Halbleiterkörper geführt ist. Zur Kontaktierung des optoelektronischen Halbleiterkörpers ist eine planare Leitstruktur in Form einer Metallisierung über die Isolationsschicht zu Kontaktstellen des Halbleiterkörpers und zu einer Leiterbahn des Substrats geführt.

Bei herkömmlichen planaren Kontaktierungstechniken liegt die Isolationsschicht meist eng an Seiten des Halbleiterkörpers an, wodurch die Isolationsschicht an Seitenflächen des Halbleiterkörpers steile Flanken bildet, die sich im Herstellungsverfahren nur schwer belichten lassen. Ferner können an den Seitenflächen des Halbleiterkörpers Hohlräume unterhalb der Isolationsschicht entstehen, die die Zuverlässigkeit des Bauelements nachteilig beeinträchtigen können.

Die Druckschrift DE 10 2007 043 001 A1 betrifft ein Bandverfahren für elektronische Bauelemente.

In der Druckschrift WO 2007/025521 A2 ist ein Verfahren zur Herstellung eines Halbleiterbauelements mit einer planaren Kontaktierung beschrieben.

Eine Leuchtdiodenandordnung findet sich in der Druckschrift DE 10 2007 021 009 A1.

Angaben über ein optoelektronisches Bauelement sind in der Druckschrift DE 10 2008 005 497 A1 enthalten.

Der Erfindung liegt die Aufgabe zugrunde, ein verbessertes optoelektronisches Modul bereitzustellen, das insbesondere eine geringe Bauhöhe und gleichzeitig eine hohe Zuverlässigkeit aufweist und sich ferner durch ein vereinfachtes Herstellungsverfahren auszeichnet.

Diese Aufgaben werden durch ein optoelektronisches Modul mit den Merkmalen des Patentanspruchs 1 und ein Verfahren zu dessen Herstellung mit den Merkmalen des Patentanspruchs 10 gelöst. Vorteilhafte Ausführungsformen und bevorzugte Weiterbildungen des Moduls und des Verfahrens zu dessen Herstellung sind Gegenstand der abhängigen Ansprüche.

Erfindungsgemäß ist ein optoelektronisches Modul vorgesehen, das zumindest einen ersten Halbleiterkörper mit einer Strahlungsaustrittsseite aufweist. Auf der Strahlungsaustrittsseite ist zumindest ein elektrischer Anschlussbereich angeordnet, wobei der erste Halbleiterkörper mit einer der Strahlungsaustrittsseite gegenüberliegenden Seite auf einem Träger angeordnet ist. Auf dem Träger seitlich neben dem ersten Halbleiterkörper ist ein Isolationsmaterial angeordnet, das eine Kehle ausbildet und formschlüssig an den Halbleiterkörper angrenzt. Auf dem ersten Halbleiterkörper und dem Isolationsmaterial ist zumindest bereichsweise eine Isolationsschicht angeordnet, wobei auf der Isolationsschicht zu planaren Kontaktierung des ersten Halbleiterkörpers zumindest eine planare Leitstruktur angeordnet ist, die mit dem elektrischen Anschlussbereich des ersten Halbleiterkörpers elektrisch leitend verbunden ist.

Durch die planare Kontaktierung des Halbleiterkörpers ergibt sich mit Vorteil eine besonders geringe Bauhöhe des Moduls. So kann mit Vorteil ein kompaktes Modul bereitgestellt werden, bei dem eine nahe Anordnung der Leitstrukturen an den Halbleiterkörper ermöglicht wird.

Durch das Isolationsmaterial, das an Seitenflächen des Halbleiterkörpers angeordnet ist und direkt an diese angrenzt, können mit Vorteil Hohlräume zwischen Isolationsschicht und Träger vermieden werden, wodurch sich mit Vorteil die Zuverlässigkeit des Moduls erhöht.

Ferner sind durch das Isolationsmaterial steile Flanken der Isolationsschicht an Seitenflächen des Halbleiterkörpers vermieden. Steile Flanken der Isolationsschicht führen beispielsweise zu einem erschwerten Belichtungsprozess während der Herstellung des Moduls, wodurch nachteilig die Zuverlässigkeit des Moduls beeinträchtigt werden kann. Durch das Isolationsmaterial, das seitlich der Halbleiterkörper zwischen Isolationsschicht und Träger angeordnet ist, sodass keine steilen Flanken der Isolationsschicht entstehen, wird eine vereinfachte Herstellung sowie eine hohe Zuverlässigkeit des Moduls ermöglicht.

Das Isolationsmaterial bildet seitlich neben dem ersten Halbleiterkörper eine Kehle aus. So ist das Isolationsmaterial kehlenförmig und formschlüssig an dem Halbleiterkörper angeordnet, wodurch Hohlräume zwischen Isolationsmaterial und Träger im Bereich seitlich neben dem ersten Halbleiterkörper vermieden werden können. Bevorzugt ist die Isolationsschicht direkt auf dem Isolationsmaterial angeordnet, sodass zwischen Isolationsmaterial und Isolationsschicht keine Hohlräume ausgebildet sind. Dadurch kann mit Vorteil die Zuverlässigkeit des Moduls verbessert werden.

Das optoelektronische Modul weist demnach zwei separate isolierende Komponenten auf, die zumindest teilweise den ersten Halbleiterkörper umgeben. Seitlich neben dem ersten Halbleiterkörper ist das Isolationsmaterial angeordnet. Auf dem Isolationsmaterial und vorzugsweise direkt auf dem Halbleiterkörper ist die Isolationsschicht angeordnet.

Insbesondere können so kritische Seitenflächen des Halbleiterkörpers elektrisch isoliert ausgebildet sein. Bevorzugt kann durch die isolierende Zwei-Komponentenausbildung, also durch die Isolationsschicht und durch das Isolationsmaterial, ein Übersprechen, insbesondere ein so genanntes "Cross-Talking", vermieden werden.

Bei einem erfindungsgemäßen Modul ist die Gefahr der Entstehung von Hohlräumen und/oder Kavitäten in dem Modul signifikant reduziert. Ferner ergeben sich folgende Vorteile:
- Ersparnis von Prozesszeit und damit Prozesskosten basierend auf einem vereinfachten Belichtungsprozess der Isolationsschicht,
- höhere Ausbeute durch geglättete Topographie und bessere Belichtungsqualität, da durch das Isolationsmaterial Zwischenräume zwischen den Halbleiterkörpern und seitlich der Halbleiterkörper vermieden werden können,
- Vermeidung von Reliability-Problemen durch scharfe Konturen und/oder Topographien,
- 3D-Strutkurierbarkeit der Flankenbereiche des Halbleiterkörpers,
- hohe Isolation des Halbleiterkörpers auch im Seitenbereich des Halbleiterkörpers,
- Schutz gegen beispielsweise Umwelteinflüsse ("Harsh Environment").

Der Halbleiterkörper ist bevorzugt ein Halbleiterchip, besonders bevorzugt eine Licht emittierende Diode (LED) oder eine Laserdiode. Besonders bevorzugt ist der Halbleiterkörper ein Dünnfilmhalbleiterkörper. Ein Dünnfilmhalbleiterkörper ist insbesondere ein Halbleiterkörper, während dessen Herstellung das Aufwachssubstrat abgelöst worden ist.

Der Halbleiterkörper weist vorzugsweise eine strahlungsemittierende aktive Schicht auf. Die aktive Schicht weist vorzugsweise einen pn-Übergang, eine Doppelheterostruktur, eine Einfachquantentopfstruktur (SQW, single quantum well) oder eine Mehrfachquantentopfstruktur (MQW, multi quantum well) zur Strahlungserzeugung auf. Der Halbleiterkörper basiert vorzugsweise auf einem Nitrid-, Phosphid- oder Arsenidverbindungshalbleiter.

Erfindungsgemäß ist zumindest ein zweiter Halbleiterkörper neben dem ersten Halbleiterkörper auf dem Träger angeordnet. Das Isolationsmaterial grenzt in Bereichen zwischen den Halbleiterkörpern formschlüssig an die Halbleiterkörper an. Das an äußere Seiten des ersten Halbleiterkörpers und des zweiten Halbleiterkörpers angrenzende Isolationsmaterial bildet jeweils eine Kehle aus und grenzt formschlüssig an die Halbleiterkörper an.

Das Modul kann demnach sowohl in einer so genannten Einzelchip-Aufbautechnologie oder in einer Multichip-Array-Aufbautechnologie gefertigt sein. Durch die Zwei-Komponentenisolierung mittels des Isolationsmaterials und der Isolationsschicht können insbesondere unterschiedliche Dicken verschiedener Halbleiterkörper sowie unterschiedliche Abstände zueinander zwischen den Halbleiterkörpern ausgeglichen sein. Beispielsweise kann auf dem Träger eine Mehrzahl von Halbleiterkörpern angeordnet sein, die sich in der Wellenlänge der von den Halbleiterkörpern emittierten Strahlung unterscheiden, und somit unterschiedliche Farben emittieren. Dadurch kann das Modul entsprechen der jeweiligen Verwendung mit unterschiedlichen Halbleiterkörpern bestückt sein. Ein flexibles Modul, das insbesondere auf die jeweilige Anwendung angepasst ist, ermöglicht sich mit Vorteil.

Bei einer weiteren bevorzugten Ausgestaltung des optoelektronischen Moduls ist zwischen dem ersten Halbleiterkörper und dem zweiten Halbleiterkörper eine Mehrzahl von weiteren Halbleiterkörpern angeordnet, wobei das Isolationsmaterial jeweils in Bereichen zwischen benachbarten Halbleiterkörpern formschlüssig an die Halbleiterkörper angrenzt.

Dadurch können mit Vorteil Hohlräume und Kavitäten in dem Modul vermieden werden, wodurch die Zuverlässigkeit des Moduls mit Vorteil erhöht wird. Durch den Zweikomponentenaufbau der Isolation der Halbleiterkörper lassen sich mit Vorteil insbesondere Halbleiterkörper unterschiedlicher Dicke, Größe und/oder Abstand problemlos kombinieren, ohne dabei die Zuverlässigkeit des Moduls zu beeinträchtigen, wobei aufwändige Prozessoptimierungen mit Vorteil nicht notwendig sind, wodurch sich die Prozesszeit und damit die Prozesskosten minimieren.

Bei einer weiteren bevorzugten Ausgestaltung des optoelektronischen Moduls ist das Isolationsmaterial und/oder die Isolationsschicht für die von dem Halbleiterkörper emittierte Strahlung oder von den jeweiligen Halbleiterkörpern emittierte Strahlung transparent. Die von dem Halbleiterkörper oder den Halbleiterkörpern emittierte Strahlung kann so durch die Isolationsschicht und das Isolationsmaterial ausgekoppelt werden, ohne dabei wesentliche optische Verluste zu erleiden.

Bei einer weiteren bevorzugten Ausgestaltung des optoelektronischen Moduls enthält das Isolationsmaterial und/oder die Isolationsschicht ein Konversionsmaterial. Das Konversionsmaterial in der Isolationsschicht und/oder dem Isolationsmaterial absorbiert vorzugsweise zumindest teilweise Strahlung, die von dem oder den Halbleiterkörpern emittiert wird, und reemittiert eine Sekundärstrahlung in einem anderen Wellenlängenbereich. Dadurch emittiert das Modul Mischstrahlung, die die von dem Halbleiterkörper oder den Halbleiterkörpern emittierte Strahlung und die Sekundärstrahlung des Konversionsmaterials enthält. Vorzugsweise kann so beispielsweise ein Modul erzeugt werden, das Mischstrahlung im weißen Farbort emittiert.

Alternativ kann auf dem Halbleiterkörper oder auf den Halbleiterkörpern insbesondere auf der Strahlungsaustrittsseite jeweils ein Konversionsmaterial, beispielsweise in Form eines Plättchens, angeordnet sein. Ein derartiges Konversionsplättchen kann beispielsweise jeweils auf der Strahlungsaustrittsseite des jeweiligen Halbleiterkörpers aufgeklebt oder mittels eines Siebdruckverfahrens aufgebracht sein.

Die Strahlungsaustrittsseite der Halbleiterkörper kann dabei frei von Isolationsmaterial und von der Isolationsschicht sein. Ist die Isolationsschicht transparent ausgebildet, kann die Strahlungsaustrittsseite alternativ mit der Isolationsschicht bedeckt sein.

Bei einer bevorzugten Ausgestaltung des Moduls ist das Isolationsmaterial UV-beständig. Es enthält das Isolationsmaterial ein Polymermaterial. Es enthält auch die Isolationsschicht ein Polymermaterial. Beispielsweise kann das Isolationsmaterial Silikon enthalten und die Isolationsschicht eine Silikonfolie sein.

Bei einer besonders bevorzugten Ausgestaltung des Moduls ist die Isolationsschicht eine Multifunktionsfolie, die zumindest eine weitere Funktionalität erhöht, ausgewählt aus einem Schutz gegen Umwelteinflüsse, einem UV-Schutz, einem Schutz vor Wasseraufnahme, einem Degradationsschutz, einem Schutz vor Temperatureinflüssen und/oder einem Schutz vor Rissbildung. Eine Multifunktionsfolie ist dem Fachmann auch bekannt unter "Hybridfolie" oder "Multilayer".

Dadurch können mit Vorteil mehrere Anforderungen an das Modul erfüllt werden. Insbesondere ist die Isolationsschicht in diesem Fall nicht nur zur Isolierung der oder des Halbleiterkörpers vorgesehen, sondern erfüllt weiter beispielsweise eine Schutzfunktion der Halbleiterkörper auf dem Träger.

Zur planaren Kontaktierung des ersten Halbleiterkörpers oder der Mehrzahl von Halbleiterkörpern ist auf der Isolationsschicht zumindest eine planare Leitstruktur angeordnet. Die planaren Leitstrukturen beziehungsweise die planare Leitstruktur sind beispielsweise als Metallstrukturen ausgebildet. Planare Leitstrukturen, insbesondere die planare Kontaktierung von Halbleiterkörpern, sind dem Fachmann beispielsweise aus der Druckschrift DE 103 53 679 A1 bekannt und werden daher an dieser Stelle nicht näher erörtert.

Sind auf dem Träger eine Mehrzahl von Halbleiterkörpern angeordnet, können diese jeweils mit einer planaren Leitstruktur miteinander elektrisch leitend verbunden sein. Auch in diesem Fall sind die planaren Leitstrukturen vorzugsweise auf der Isolationsschicht angeordnet und so von den Halbleiterkörpern jeweils mittels der Isolationsschicht elektrisch isoliert.

Die planaren Leitstrukturen sind jeweils mit elektrischen Anschlussbereichen der Halbleiterkörper elektrisch leitend verbunden. Hierzu weist die Isolationsschicht in Bereichen der elektrischen Anschlussbereiche der Halbleiterkörper jeweils eine Aussparung auf, durch die die planare Leitstruktur jeweils geführt ist.

Ein erfindungsgemäßes Verfahren zum Herstellen eines optoelektronischen Moduls umfasst die folgenden Schritte:
a) Anordnen eines ersten Halbleiterkörpers mit einer von einer Strahlungsaustrittsseite abgewandte Seite auf einem Träger,
b) Aufbringen eines Isolationsmaterials seitlich neben dem ersten Halbleiterkörper auf dem Träger derart, dass das Isolationsmaterial als Kehle und formschlüssig an den Halbleiterkörper ausgebildet wird,
c) nachfolgendes Aufbringen einer Isolationsschicht bereichsweise auf dem Halbleiterkörper und dem Isolationsmaterial,
d) nachfolgendes Aufbringen zumindest einer planaren Leitstruktur auf der Isolationsschicht zur elektrischen Kontaktierung des ersten Halbleiterkörpers.

Vor dem Aufbringen der Isolationsschicht auf dem Halbleiterkörper wird demnach das Isolationsmaterial seitlich neben dem Halbleiterkörper auf dem Träger aufgebracht. Das Isolationsmaterial ist dabei derart aufgebracht, dass das Isolationsmaterial eine Kehle bildet und formschlüssig an den Halbleiterkörper angrenzt. Auf dem Isolationsmaterial wird anschließend die Isolationsschicht aufgebracht. Das Isolationsmaterial bildet demnach eine Rampe für die Isolationsschicht. Durch die elektrische Isolierung der Halbleiterkörper mittels der zwei Komponenten, also des Isolationsmaterials und der Isolationsschicht, sind mit Vorteil Hohlräume sowie steile Flanken vermieden, wodurch mit Vorteil die Zuverlässigkeit des Moduls erhöht wird.

Insbesondere ist das Isolationsmaterial eine separate Komponente des Moduls. Bevorzugt wird das Isolationsmaterial in einem separaten Verfahrensschritt von dem Aufbringprozess der Isolationsschicht aufgebracht.

Zur elektrischen Isolation der Halbleiterkörper auf dem Träger findet insbesondere ein Zweistufenprozess statt. Im ersten Schritt wird das Isolationsmaterial aufgebracht, beispielsweise durch ein Siebdruckverfahren oder eines Schablonendruckverfahrens. Im zweiten Schritt wird die Isolationsschicht aufgebracht, beispielsweise mittels eines Laminierprozesses, eines Schablonen- oder Siebdruckverfahrens, eines Dispens- oder eines Jett-Prozesses.

Erfindungsgemäß wird im Verfahrensschritt a) zumindest ein zweiter Halbleiterkörper neben dem ersten Halbleiterkörper auf dem Träger angeordnet, wobei im Verfahrensschritt b) das Isolationsmaterial in Bereichen zwischen den Halbleiterkörpern formschlüssig an die Halbleiterkörper und das an äußere Seiten des ersten Halbleiterkörpers und des zweiten Halbleiterkörpers angrenzende Isolationsmaterial als Kehle und formschlüssig an die Halbleiterkörper ausgebildet wird.

Vorzugsweise wird im Verfahrensschritt a) zwischen dem ersten Halbleiterkörper und dem zweiten Halbleiterkörper eine Mehrzahl von weiteren Halbleiterkörpern angeordnet, wobei das Isolationsmaterial jeweils in Bereichen zwischen benachbarten Halbleiterkörpern formschlüssig an die Halbleiterkörper ausgebildet wird.

Mit dem Zweistufenprozess der Isolierung der Halbleiterkörper lassen sich mit Vorteil Halbleiterkörper unterschiedlicher Dicke, Größe und Abstand problemlos auf einem Träger zu einem Modul kombinieren, ohne dass dabei aufwändige Prozessoptimierungen notwendig sind. Insbesondere kann die Gefahr der Entstehung von Hohlräumen oder Kavitäten signifikant reduziert werden.

Nach Aufbringen der Isolationsschicht auf den Halbleiterkörpern und dem Isolationsmaterial werden zumindest eine planare Leitstruktur oder planare Leitstrukturen beispielsweise in Form von Metallstrukturen aufgebracht.

Weitere Merkmale, Vorteile, bevorzugte Ausgestaltungen und Zweckmäßigkeiten des optoelektronischen Moduls und des Verfahrens zu dessen Herstellung ergeben sich aus den im Folgenden in Verbindung mit den Figuren 1 bis 3 erläuterten Ausführungsbeispielen. Es zeigen:
- Figur 1: einen schematischen Querschnitt eines Ausführungsbeispiels eines erfindungsgemäßen Moduls,
- Figuren 2 und 3: jeweils schematische Querschnitte von Ausführungsbeispielen eines erfindungsgemäßen Moduls im Herstellungsverfahren, und
- Figuren 4A und 4B: jeweils einen schematischen Querschnitt von Ausführungsbeispielen von Modulen gemäß dem Stand der Technik.

Gleiche oder gleich wirkende Bestandteile sind jeweils mit den gleichen Bezugszeichen versehen. Die dargestellten Bestandteile sowie die Größenverhältnisse der Bestandteile untereinander sind nicht als maßstabsgerecht anzusehen.

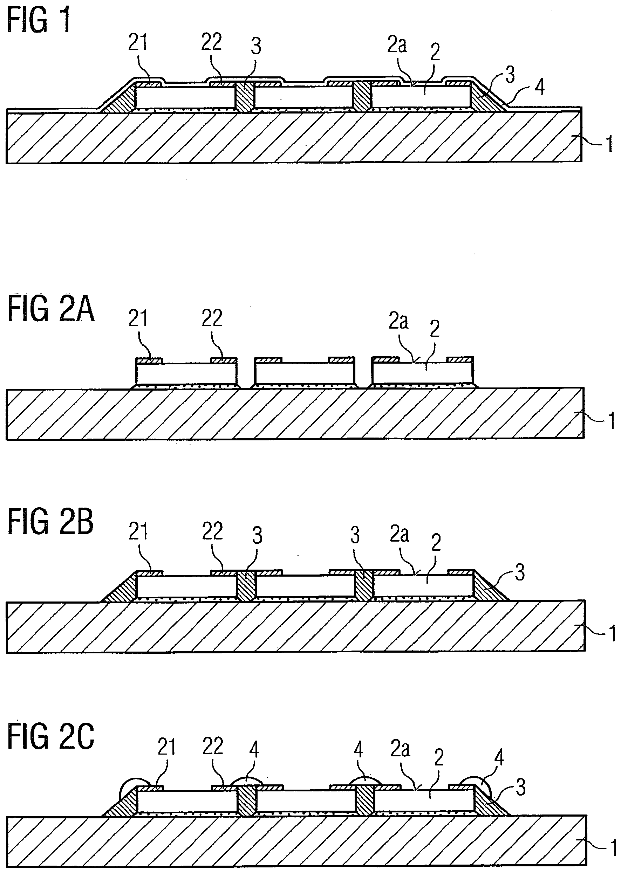

In Figur 1 ist ein optoelektronisches Modul dargestellt, das einen Träger 1 und eine Mehrzahl darauf angeordneter Halbleiterkörper 2 aufweist. Die Halbleiterkörper 2 weisen jeweils eine strahlungsemittierende aktive Schicht zur Erzeugung von elektromagnetischer Strahlung auf. Beispielsweise sind die Halbleiterkörper 2 jeweils ein Halbleiterchip, bevorzugt eine Licht emittierende Diode (LED) oder eine Laserdiode.

Die Halbleiterkörper 2 weisen jeweils auf der dem Träger 1 zugewandten Seite eine Kontaktfläche auf. Insbesondere sind die Halbleiterkörper 2 über die Kontaktfläche jeweils mit Leiterbahnen, die beispielsweise auf dem Träger 1 angeordnet sind, oder mit dem Träger 1, das in diesem Fall ein elektrisch leitfähiges Material aufweist, elektrisch leitend kontaktiert.

Auf der von dem Träger 1 abgewandten Seite der Halbleiterkörper 2 ist jeweils eine Strahlungsaustrittsseite 2a angeordnet. Durch die Strahlungsaustrittsseite 2a wird vorzugsweise ein Großteil der von der aktiven Schicht emittierten Strahlung aus dem jeweiligen Halbleiterkörper 2 ausgekoppelt.

Auf der Strahlungsaustrittsseite 2a der Halbleiterkörper 2 sind jeweils elektrische Anschlussbereiche 21, 22 angeordnet. Insbesondere sind die elektrischen Anschlussbereiche 21, 22 jeweils in einem Seitenbereich der Strahlungsaustrittsseite 2a angeordnet, sodass die elektrischen Anschlussbereiche 21, 22 nicht notwendigerweise transparent für die von den Halbleiterkörpern 2 emittierte Strahlung sein müssen.

Die elektrischen Anschlussbereiche 21, 22 können vorzugsweise miteinander auf der Strahlungsaustrittsseite 2a verbunden sein. Beispielsweise sind die elektrischen Anschlussbereiche 21, 22 rahmenförmig, beispielsweise rechteckförmig, auf der Strahlungsaustrittsseite 2a angeordnet, sodass im Betrieb der Halbleiterkörper 2 eine Stromaufweitung erzeugt wird. Seitlich neben den einzelnen Halbleiterkörpern 2 ist jeweils ein Isolationsmaterial 3 angeordnet. Insbesondere ist das Isolationsmaterial 3 zwischen benachbarten Halbleiterkörpern 2 derart angeordnet, dass das Isolationsmaterial 3 in diesen Bereichen formschlüssig an die einzelnen Halbleiterkörper 2 angrenzt. Das an äußere Seiten der äußeren Halbleiterkörper 2 angrenzende Isolationsmaterial 3 bildet eine Kehle aus und ist ebenfalls formschlüssig an die äußeren Halbleiterkörper 2 angeordnet. Insbesondere bildet das Isolationsmaterial 3 in diesen äußeren Bereichen vorzugsweise eine Rampe aus.

Die Bereiche zwischen den einzelnen Halbleiterkörpern 2 sind somit mittels des Isolationsmaterials 3 planarisiert. Es entspricht die Höhe des Isolationsmaterials 3 in Bereichen zwischen den Halbleiterkörpern 2 der Höhe der jeweiligen Halbleiterkörper 2. Ebenfalls entspricht die maximale Höhe des als Kehle ausgebildeten Isolationsmaterials 3 an den äußeren Seiten der Halbleiterkörper 2 der Höhe der jeweiligen Halbleiterkörper 2.

Auf den Halbleiterkörpern 2, insbesondere auf der Strahlungsaustrittsseite 2a, sowie auf dem Isolationsmaterial 3 ist eine Isolationsschicht 4 angeordnet. Die Isolationsschicht 4 ist insbesondere auch auf dem Träger 1 in Bereichen, die die jeweiligen Halbleiterkörper 2 oder das Isolationsmaterial 3 umgeben, angeordnet.

In dem Ausführungsbeispiel der Figur 1 weist das erfindungsgemäße Modul eine Mehrzahl von Halbleiterkörpern 2 auf. Alternativ kann das Modul lediglich einen Halbleiterkörper 2 aufweisen, der auf dem Träger 1 angeordnet ist. In diesem Fall ist das Isolationsmaterial 3 an allen Seitenflächen des Halbleiterkörpers 2 als Kehle ausgebildet, wobei die Isolationsschicht 4 auf dem kehlenförmigen Isolationsmaterial 3 geführt ist.

Vorzugsweise ist die Isolationsschicht 4 für die von den Halbleiterkörpern 2 emittierte Strahlung transparent, oder zumindest teilweise transparent, sodass die von den Halbleiterkörpern 2 emittierte Strahlung an der Strahlungsaustrittsseite 2a aus dem Modul ausgekoppelt werden kann.

Alternativ kann das Isolationsmaterial 3 und/oder die Isolationsschicht 4 ein Konversionsmaterial enthalten. Das Konversionsmaterial absorbiert zumindest einen Teil der von dem jeweiligen Halbleiterkörper 2 emittierten Strahlung und reemittiert eine Sekundärstrahlung, die vorzugsweise eine von den Wellenlängenbereichen der von den Halbleiterkörpern 2 emittierten Strahlung unterschiedlichen Wellenlängenbereich aufweist. Dadurch kann mit Vorteil ein Modul ermöglicht werden, das Mischstrahlung aufweisend die von den einzelnen Halbleiterkörpern 2 emittierte Strahlung und die Sekundärstrahlung aufweist. So kann beispielsweise ein Modul erzielt werden, das weißes Licht emittiert.

Das Isolationsmaterial 3 ist vorzugsweise UV-beständig. Es enthalten das Isolationsmaterial 3 und die Isolationsschicht 4 ein Polymermaterial.

Die Isolationsschicht 4 ist vorzugsweise eine Multifunktionsfolie und erfüllt zumindest eine weitere Funktionalität, ausgewählt aus einem Schutz gegen Umwelteinflüsse, einem UV-Schutz, einem Schutz vor Wasseraufnahme, einem Degradationsschutz, einem Schutz vor Temperatureinflüssen und/oder einem Schutz vor Rissbildung.

In dem Ausführungsbeispiel der Figur 1 bedeckt die Isolationsschicht 4 die Strahlungsaustrittsseiten 2a der Halbleiterkörper 2 bis auf die elektrischen Anschlussbereiche 21, 22 vollständig. Alternativ kann jedoch die Strahlungsaustrittsseite 2a jeweils zumindest im Bereich des Strahlungsaustritts frei von der Isolationsschicht 4 sein. Bei einer freigelegten Strahlungsaustrittsseite 2a kann beispielsweise ein Konversionsmaterial, beispielsweise ein Konversionsplättchen, auf der Strahlungsaustrittsseite 2a angeordnet sein. Alternativ kann das Konversionsmaterial beispielsweise mittels Siebdrucks auf die freigelegte Strahlungsaustrittsseite 2a der Halbleiterkörper 2 aufgebracht sein.

Auf der Isolationsschicht 4 ist zur planaren Kontaktierung der Halbleiterkörper 2 zumindest eine planare Leitstruktur angeordnet, die mit den elektrischen Anschlussbereichen 21, 22 der Halbleiterkörper 2 elektrisch leitend verbunden ist (nicht dargestellt). Die Halbleiterkörper 2 sind somit vorzugsweise mittels der Kontaktfläche auf der dem Träger 1 zugewandten Seite der jeweiligen Halbleiterkörper 2 und mittels der elektrischen Anschlussbereiche 21, 22 über die planare Leitstruktur elektrisch leitend kontaktiert.

Die elektrische Isolierung der einzelnen Halbleiterkörper 2 erfolgt in dem Ausführungsbeispiel der Figur 1 in einem Zwei-Komponentenaufbau, insbesondere mittels des Isolationsmaterials 2 und der Isolationsschicht 4, wodurch herkömmlicherweise auftretende Nachteile mit Vorteil vermieden werden können.

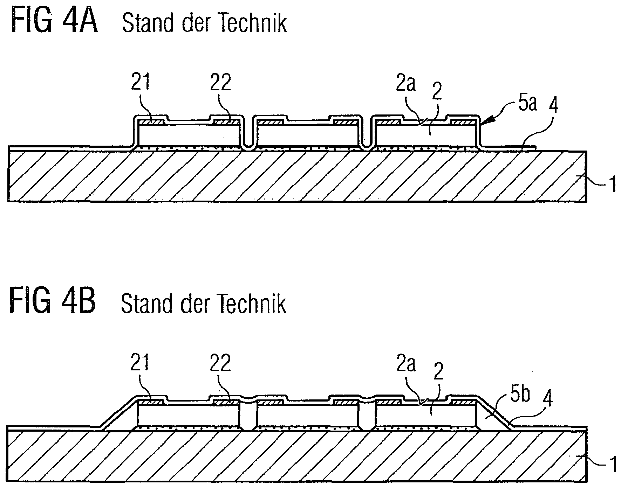

Derartige, herkömmlicherweise auftretende Nachteile, sind insbesondere in den Figuren 4A und 4B dargestellt. In den Figuren 4A und 4B ist im Unterschied zu dem in Figur 1 dargestellten Beispiel kein Isolationsmaterial zwischen den Halbleiterkörpern und an Seitenbereichen der Halbleiterkörper 2 angeordnet.

Insbesondere liegt, wie in Figur 4A dargestellt, die Isolationsschicht 4 eng an den Seitenflächen der Halbleiterkörper 2 an. Dadurch entstehen in Seitenbereichen der Halbleiterkörper 2 steile Flanken 5a der Isolationsschicht 4. Diese steilen Flanken 5a führen insbesondere zu Belichtungsproblemen bei der nachfolgenden Fototechnik, die herkömmlicherweise im Herstellungsprozess Verwendung findet. Dadurch kann nachteilig die Zuverlässigkeit des Moduls beeinträchtigt werden.

In Figur 4B ist ein weiteres herkömmliches Modul dargestellt. In diesem Fall sind zwischen Isolationsschicht 4 und Träger 1 Hohlräume 5b ausgebildet. Diese Hohlräume, die zwischen Isolationsschicht 4 und Träger 1 entstehen können, können jedoch nachteilig zu einer Beeinträchtigung der Zuverlässigkeit des Moduls führen.

Durch den erfindungsgemäßen Zwei-Komponentenaufbau der elektrischen Isolierung können derartige Nachteile, die die Zuverlässigkeit des Moduls beeinträchtigen können, mit Vorteil vermieden werden.

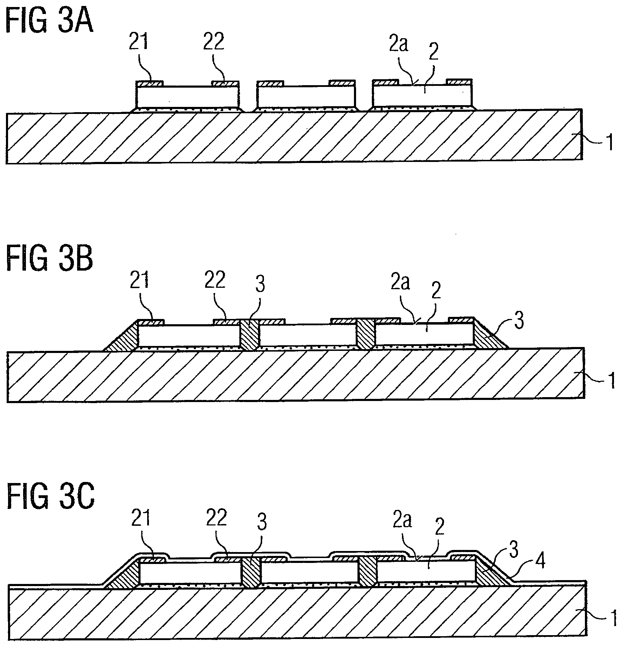

In den Figuren 2A bis 2C und 3A bis 3C sind jeweils Module während des Herstellungsverfahrens dargestellt. In den Figuren 2A und 3A werden jeweils Halbleiterkörper 2 mit einer von einer Strahlungsaustrittsseite 2a abgewandten Seite auf einem Träger 1 angeordnet. Beispielsweise werden die Halbleiterkörper 2 mittels einer Klebeschicht oder eines Lotes auf dem Träger 1 montiert.

Anschließend wird, wie in den Figuren 2B und 3B dargestellt, ein Isolationsmaterial 3 seitlich neben den Halbleiterkörpern auf dem Träger 1 angeordnet. Es wird das Isolationsmaterial 3 jeweils zwischen benachbarten Halbleiterkörpern derart angeordnet, dass das Isolationsmaterial 3 formschlüssig an die Halbleiterkörper 2 anschließt. Das Isolationsmaterial 3 füllt demnach Bereiche zwischen den Halbleiterkörpern 2 auf.

An äußere Seiten der äußeren Halbleiterkörper 2 wird das Isolationsmaterial derart angeordnet, dass es eine Kehle bildet. Ferner ist auch in diesen Bereichen das Isolationsmaterial 3 formschlüssig an die Halbleiterkörper 2 ausgebildet. Das Isolationsmaterial 3 bildet in diesen Bereichen eine Rampe aus. Hohlräume in Bereichen zwischen Halbleiterkörper, Träger und Isolationsmaterial 3 werden mit Vorteil vermieden.

Nachfolgend wird, wie in Figuren 2C und 3C dargestellt, eine Isolationsschicht 4 zumindest bereichsweise auf den Halbleiterkörpern 2 und auf dem Isolationsmaterial 3 angeordnet. In dem Ausführungsbeispiel der Figur 2C wird das Isolationsmaterial 4 lediglich bereichsweise derart auf der Strahlungsaustrittsseite 2a angeordnet, dass die Strahlungsaustrittsseite zumindest im Strahlungsaustritt frei von der Isolationsschicht 4 ist. Die Strahlungsaustrittsseite 2a der Halbleiterkörper 2 kann so beispielsweise jeweils ein nachträglich aufgebrachtes Konversationsmaterial, beispielsweise ein Konversionsplättchens, aufweisen.

Im Unterschied zu dem in Figur 2C dargestellten Ausführungsbeispiel ist die Isolationsschicht 4 in dem in Figur 3C dargestellten Ausführungsbeispiel vollständig auf der Strahlungsaustrittsseite 2a der Halbleiterkörper 2 angeordnet. Insbesondere ist in dem Ausführungsbeispiel der Figur 3C ist Isolationsschicht 4 einstückig ausgebildet, und bedeckt vollständig die Halbleiterkörper 2 sowie das Isolationsmaterial 3 und den Träger 1. In diesem Fall ist die Isolationsschicht 4 transparent für die von den Halbleiterkörpern 2 emittierte Strahlung ausgebildet oder weist ein in der Isolationsschicht 4 angeordnetes Konversionsmaterial auf.

Es wird in dem Herstellungsverfahren eines derartigen Moduls, wie in den Figuren 2 und 3 ausgeführt, ein Zweistufenprozess zur Isolierung der Halbleiterkörper 2 verwendet. Im ersten Schritt wird das Isolationsmaterial 3 auf dem Träger 1 aufgebracht. Anschließend wird die Isolationsschicht 4 auf den Halbleiterkörpern 2 und dem Isolationsmaterial 3 aufgebracht.

Das Isolationsmaterial 3 wird beispielsweise mittels eines Siebdruck oder Schablonendruckverfahrens auf dem Träger 1 aufgebracht. Die Isolationsschicht 4 ist vorzugsweise eine Folie und wird auflaminiert. Alternativ kann die Isolationsschicht 4 mittels eines Siebdruck- oder Schablonendruckverfahrens oder eines Dispens- oder Jett-Prozesses auf den Halbleiterkörpern 2, dem Isolationsmaterial 3 und dem Träger 1 aufgebracht werden.

Mit dem Zweistufenprozess zur Isolation der Halbleiterkörper 2 lassen sich mit Vorteil Halbleiterkörper unterschiedlicher Dicke, Größe und Abstand kombinieren, ohne dass aufwändige Prozessoptimierungsverfahren notwendig sind. Insbesondere kann die Gefahr der Entstehung von Hohlräumen oder Kavitäten zwischen Isolationsschicht 4 und Träger 1 signifikant reduziert werden.

Die Erfindung ist nicht durch die Beschreibung anhand der Ausführungsbeispiele auf diese beschränkt.

## Patentansprüche

1. Optoelektronisches Modul aufweisend zumindest einen ersten Halbleiterkörper (2) mit einer Strahlungsaustrittsseite (2a), auf der zumindest ein elektrischer Anschlussbereich (21, 22) angeordnet ist, wobei
- der erste Halbleiterkörper (2) mit einer der Strahlungsaustrittsseite (2a) gegenüberliegenden Seite auf einem Träger (1) angeordnet ist,
- zumindest ein zweiter Halbleiterkörper (2) neben dem ersten Halbleiterkörper (2) auf dem Träger (1) angeordnet ist,
- auf dem Träger (1) seitlich neben dem ersten Halbleiterkörper (2) und dem zweiten Halbleiterkörper (2) ein Isolationsmaterial (3) angeordnet ist, das jeweils eine Kehle ausbildet und formschlüssig an äußeren Seitenflächen der Halbleiterkörper (2) angrenzt,
- auf dem ersten Halbleiterkörper (2) und dem Isolationsmaterial (3) zumindest bereichsweise eine Isolationsschicht (4) angeordnet ist,
- auf der Isolationsschicht (4) zur planaren Kontaktierung des ersten Halbleiterkörpers (2) zumindest eine planare Leitstruktur angeordnet ist, die mit dem elektrischen Anschlussbereich (21, 22) des ersten Halbleiterkörpers (2) elektrisch leitend verbunden ist,
- das Isolationsmaterial (3) in Bereichen zwischen den Halbleiterkörpern (2) formschlüssig an die Halbleiterkörper (2) angrenzt,
- das Isolationsmaterial (3) eine Rampe für die Isolationsschicht (4) bildet, sodass durch das Isolationsmaterial (3) steile Flanken der Isolationsschicht (4) an den äußeren Seitenflächen des ersten und des zweiten Halbleiterkörpers (2) vermieden sind,
- Bereiche zwischen den Halbleiterkörpern (2) mittels des Isolationsmaterials (3) planarisiert sind, sodass eine Höhe des Isolationsmaterials (3) in diesen Bereichen zwischen den Halbleiterkörpern (2) einer Höhe der jeweiligen Halbleiterkörper (2) entspricht,
- eine maximale Höhe des als Kehle ausgebildeten Isolationsmaterials (3) an den äußeren Seitenflächen des ersten und des zweiten Halbleiterkörpers (2) der Höhe dieser Halbleiterkörper (2) entspricht, und
- das Isolationsmaterial (3) und die Isolationsschicht (4) ein Polymermaterial enthalten.

2. Optoelektronisches Modul gemäß dem vorhergehenden Anspruch, wobei
die Isolationsschicht (4) einstückig ausgebildet ist und das Isolationsmaterial (3) und den Träger (1) vollständig bedeckt,
wobei das Isolationsschicht (4) transparent für von den Halbleiterkörpern (2) emittierte Strahlung ausgebildet ist oder ein in der Isolationsschicht (4) angeordnetes Konversionsmaterial aufweist.

3. Optoelektronisches Modul gemäß Anspruch 1 oder 2, wobei
- zwischen dem ersten Halbleiterkörper (2) und dem zweiten Halbleiterkörper (2) eine Mehrzahl von weiteren Halbleiterkörpern (2) angeordnet ist, und
- das Isolationsmaterial (3) jeweils in Bereichen zwischen benachbarten Halbleiterkörpern (2) formschlüssig an die Halbleiterkörper (2) angrenzt.

4. Optoelektronisches Modul gemäß einem der vorhergehenden Ansprüche, wobei
das Isolationsmaterial (3) und/oder die Isolationsschicht (4) ein Konversionsmaterial enthält.

5. Optoelektronisches Modul gemäß einem der Ansprüche 1 bis 3, wobei
das Isolationsmaterial (3) und/oder die Isolationsschicht (4) transparent sind.

6. Optoelektronisches Modul gemäß einem der vorhergehenden Ansprüche, wobei
das Isolationsmaterial (3) UV-beständig ist.

7. Optoelektronisches Modul gemäß einem der vorhergehenden Ansprüche, wobei
die elektrischen Anschlussbereiche (21, 22) jeweils in einem Seitenbereich auf den Strahlungsaustrittsseiten (2a) angeordnet sind und die elektrischen Anschlussbereiche (21, 22) miteinander auf den jeweiligen Strahlungsaustrittsseiten (2a) verbunden sind, und
wobei die elektrischen Anschlussbereiche (21, 22) rahmenförmig geformt sind, sodass im Betrieb der Halbleiterkörper (2) eine Stromaufweitung durch die elektrischen Anschlussbereiche (21, 22) erfolgt.

8. Optoelektronisches Modul gemäß einem der vorhergehenden Ansprüche, wobei
die Strahlungsaustrittsseiten (2a) zumindest im Bereich des Strahlungsaustritts frei von der Isolationsschicht (4) sind.

9. Optoelektronisches Modul gemäß einem der vorhergehenden Ansprüche, wobei
die Isolationsschicht (4) eine Multifunktionsfolie ist und zumindest eine weitere Funktionalität erfüllt, ausgewählt aus einem Schutz gegen Umwelteinflüsse, einem UV-Schutz, einem Schutz vor Wasseraufnahme, einem Degradationsschutz, einem Schutz vor Temperatureinflüssen und/oder einem Schutz vor Rissbildung.

10. Verfahren zum Herstellen eines optoelektronischen Moduls nach einem der vorhergehenden Ansprüche mit den Verfahrensschritten:
A) Anordnen eines ersten Halbleiterkörpers (2) mit einer von einer Strahlungsaustrittsseite (2a) abgewandten Seite auf einem Träger (1),
B) Aufbringen eines Isolationsmaterials (3) seitlich neben dem ersten Halbleiterkörper (2) auf dem Träger (1) derart, dass das Isolationsmaterial (3) als Kehle und formschlüssig an den Halbleiterkörper (2) ausgebildet wird,
C) nachfolgendes Aufbringen einer Isolationsschicht (4) bereichsweise auf dem Halbleiterkörper (2) und dem Isolationsmaterial (3),
D) nachfolgendes Aufbringen zumindest einer planaren Leitstruktur auf der Isolationsschicht (4) zur elektrischen Kontaktierung des Halbleiterkörpers (2), wobei
- im Verfahrensschritt A) der zweite Halbleiterkörper (2) neben dem ersten Halbleiterkörper (2) auf dem Träger (1) angeordnet wird, und
- im Verfahrensschritt B) das Isolationsmaterial (3) in Bereichen zwischen den Halbleiterkörpern (2) formschlüssig an die Halbleiterkörper (2) und das an äußere Seiten des ersten Halbleiterkörpers (2) und des zweiten Halbleiterkörpers (2) angrenzende Isolationsmaterial (3) als Kehle und formschlüssig an die Halbleiterkörper (2) ausgebildet wird,
sodass Bereiche zwischen den Halbleiterkörpern mittels des Isolationsmaterials planarisiert sind, sodass eine Höhe des Isolationsmaterials in diesen Bereichen zwischen den Halbleiterkörpern einer Höhe der jeweiligen Halbleiterkörper entspricht und eine maximale Höhe des als Kehle ausgebildeten Isolationsmaterials an den äußeren Seitenflächen des ersten und des zweiten Halbleiterkörpers der Höhe dieser Halbleiterkörper entspricht,
sodass bei einer dem Schritt D) nachfolgenden Fototechnik ein Belichtungsprozess durch die Vermeidung von steilen Flanken der Isolationsschicht (4) ermöglicht wird.

11. Verfahren gemäß Anspruch 10, wobei
im Verfahrensschritt A) zwischen dem ersten Halbleiterkörper (2) und dem zweiten Halbleiterkörper (2) eine Mehrzahl von weiteren Halbleiterkörpern (2) angeordnet wird und das Isolationsmaterial (3) jeweils in Bereichen zwischen benachbarten Halbleiterkörpern (2) formschlüssig an die Halbleiterkörper (2) ausgebildet wird.

12. Verfahren gemäß einem der vorhergehenden Ansprüche 10 oder 11, wobei
der Verfahrensschritt B) und/oder der Verfahrensschritt C) ein Schablonen- oder Siebdruck-Verfahren umfasst.

13. Verfahren gemäß einem der vorhergehenden Ansprüche 10 bis 12, wobei
der Verfahrensschritt C) einen Laminierprozess umfasst.

14. Verfahren gemäß einem der vorhergehenden Ansprüche 10 bis 12, wobei
der Verfahrensschritt C) einen Dispens- oder Jet-Prozess umfasst.

## Claims

1. Optoelectronic module comprising at least one first semiconductor body (2) having a radiation exit side (2a), on which at least one electrical connection region (21, 22) is arranged,
wherein
- the first semiconductor body (2) is arranged by a side situated opposite the radiation exit side (2a) on a carrier (1),
- at least one second semiconductor body (2) is arranged alongside the first semiconductor body (2) on the carrier (1)
- an insulation material (3) is arranged on the carrier (1) laterally alongside the first semiconductor body (2) and the second semiconductor body (2), said insulation material in each case forming a channel and adjoining outer side surfaces of the semiconductor body (2) in a positively locking manner,
- an insulation layer (4) is arranged at least regionally on the first semiconductor body (2) and the insulation material (3),
- at least one planar conductive structure is arranged on the insulation layer (4) for the planar contacting of the first semiconductor body (2) and is electrically conductively connected to the electrical connection region (21, 22) of the first semiconductor body (2),
- the insulation material (3) in regions between the semiconductor bodies (2) adjoins the semiconductor bodies (2) in a positively locking manner,
- the insulation material (3) forms a ramp for the insulation layer (4), such that the insulation material (3) prevents steep flanks of the insulation layer (4) at the outer side surfaces of the first and second semiconductor bodies (2),
- regions between the semiconductor bodies (2) are planarized by means of the insulation material (3), such that a height of the insulation material (3) in these regions between the semiconductor bodies (2) corresponds to a height of the respective semiconductor bodies (2),
- a maximum height of the insulation material (3) formed as a channel at the outer side surfaces of the first and second semiconductor bodies (2) corresponds to the height of said semiconductor bodies (2), and
- the insulation material (3) and the insulation layer (4) contain a polymer material.

2. Optoelectronic module according to the preceding claim, wherein
the insulation layer (4) is formed integrally and completely covers the insulation material (3) and the carrier (1),
wherein the insulation layer (4) is formed such that it is transparent to radiation emitted by the semiconductor bodies (2) or comprises a conversion material arranged in the insulation layer (4).

3. Optoelectronic module according to Claim 1 or 2, wherein
- a plurality of further semiconductor bodies (2) is arranged between the first semiconductor body (2) and the second semiconductor body (2), and
- the insulation material (3) in each case in regions between adjacent semiconductor bodies (2) adjoins the semiconductor bodies (2) in a positively locking manner.

4. Optoelectronic module according to any of the preceding claims, wherein
the insulation material (3) and/or the insulation layer (4) contain(s) a conversion material.

5. Optoelectronic module according to any of Claims 1 to 3, wherein
the insulation material (3) and/or the insulation layer (4) are/is transparent.

6. Optoelectronic module according to any of the preceding claims, wherein
the insulation material (3) is UV-resistant.

7. Optoelectronic module according to any of the preceding claims, wherein
the electrical connection regions (21, 22) are arranged in each case in a side region on the radiation exit side (2a) and the electrical connection regions (21, 22) are connected to one another on the respective radiation exit sides (2a), and
wherein the electrical connection regions (21, 22) are shaped in a frame-shaped fashion, such that current spreading is effected by the electrical connection regions (21, 22) during the operation of the semiconductor bodies (2).

8. Optoelectronic module according to any of the preceding claims, wherein
the radiation exit sides (2a) at least in the region of the radiation exit are free of the insulation layer (4).

9. Optoelectronic module according to any of the preceding claims, wherein
the insulation layer (4) is a multi-function film and fulfils at least one further functionality, selected from protection against environmental influences, UV protection, protection against water absorption, protection against degradation, protection against temperature influences and/or protection against cracking.

10. Method for producing an optoelectronic module according to any of the preceding claims comprising the following method steps:
A) arranging a first semiconductor body (2) with a side facing away from a radiation exit side (2a) on a carrier (1),
B) applying an insulation material (3) alongside the first semiconductor body (2) on the carrier (1) in such a way that the insulation material (3) is formed as a channel and in a positively locking manner onto the semiconductor body (2),
C) subsequently applying an insulation layer (4) regionally on the semiconductor body (2) and the insulation material (3),
D) subsequently applying at least one planar conductive structure on the insulation layer (4) for electrically contacting the semiconductor body (2),
wherein
- in method step A) the second semiconductor body (2) is arranged alongside the first semiconductor body (2) on the carrier (1), and
- in method step B) the insulation material (3) in regions between the semiconductor bodies (2) is formed in a positively locking manner onto the semiconductor bodies (2) and the insulation material (3) adjoining outer sides of the first semiconductor body (2) and of the second semiconductor body (2) is formed as a channel and in a positively locking manner onto the semiconductor bodies (2) such that regions between the semiconductor bodies are planarized by means of the insulation material, such that a height of the insulation material in these regions between the semiconductor bodies corresponds to a height of the respective semiconductor bodies and a maximum height of the insulation material formed as a channel at the outer side surfaces of the first and second semiconductor bodies corresponds to the height of said semiconductor bodies, such that in a phototechnique succeeding step D) an exposure process is made possible by the avoidance of steep flanks of the insulation layer (4).

11. Method according to Claim 10, wherein
in method step A) a plurality of further semiconductor bodies (2) is arranged between the first semiconductor body (2) and the second semiconductor body (2), and the insulation material (3) in each case in regions between adjacent semiconductor bodies (2) is formed in a positively locking manner onto the semiconductor bodies (2).

12. Method according to either of the preceding Claims 10 and 11, wherein
method step B) and/or method step C) comprises a stencil or screen printing method.

13. Method according to any of the preceding Claims 10 to 12, wherein
method step C) comprises a laminating process.

14. Method according to any of the preceding Claims 10 to 12, wherein
method step C) comprises a dispensing or jetting process.

## Revendications

1. Module optoélectronique présentant
au moins un premier corps semi-conducteur (2) qui présente un côté (2a) de sortie de rayonnement sur lequel est prévue au moins une partie (21, 22) de raccordement électrique,
le premier corps semi-conducteur (2) étant disposé sur un support (1) par son côté opposé au côté (2a) de sortie de rayonnement,
au moins un deuxième corps semi-conducteur (2) étant disposé sur le support (1) à côté du premier corps semi-conducteur (2),
un matériau isolant (3) qui forme un biseau et qui est adjacent en correspondance géométrique aux surfaces latérales extérieures des corps semi-conducteurs (2) étant disposé sur le support (1) latéralement à côté du premier corps semi-conducteur (2) et du deuxième corps semi-conducteur (2),
une couche isolante (4) étant disposée sur au moins certaines parties du premier corps semi-conducteur (2) et du matériau isolant (3),
au moins une structure conductrice plane reliée de manière électriquement conductrice à la partie (21, 22) de raccordement électrique du premier corps semi-conducteur (2) étant disposée sur la couche isolante (4) pour assurer un contact plan avec le premier corps semi-conducteur (2),
le matériau isolant (3) étant adjacent en correspondance géométrique aux corps semi-conducteurs (2) dans les zones situées entre les corps semi-conducteurs (2),
le matériau isolant (3) formant une rampe pour la couche isolante (4), de manière à éviter la formation par le matériau isolant (3) de flancs accusés de la couche isolante (4) sur les surfaces latérales extérieures du premier et du deuxième corps semi-conducteur (2),
les zones situées entre les corps semi-conducteurs (2) étant planées au moyen du matériau isolant (3) de telle sorte que dans ces zones situées entre les corps semi-conducteurs (2), la hauteur du matériau isolant (3) corresponde à la hauteur de chaque corps semi-conducteur (2),
la hauteur maximale du matériau isolant (3) configuré en biseau sur les surfaces latérales extérieures du premier et du deuxième corps semi-conducteur (2) correspondant à la hauteur de ces corps semi-conducteurs (2) et
le matériau isolant (3) et la couche isolante (4) contenant un matériau polymère.

2. Module optoélectronique selon la revendication précédente, dans lequel la couche isolante (4) est formée d'un seul tenant et recouvre complètement le matériau isolant (3) et le support (1), la couche isolante (4) étant transparente pour le rayonnement émis par les corps semi-conducteurs (2) ou présentant un matériau de conversion disposé dans la couche isolante (4).

3. Module optoélectronique selon les revendications 1 ou 2, dans lequel plusieurs autres corps semi-conducteurs (2) sont disposés entre le premier corps semi-conducteur (2) et le deuxième corps semi-conducteur (2) et dans lequel le matériau isolant (3) est adjacent en correspondance géométrique aux corps semi-conducteurs (2) dans les zones situées entre des corps semi-conducteurs (2) voisins.

4. Module optoélectronique selon l'une des revendications précédentes, dans lequel le matériau isolant (3) et/ou la couche isolante (4) contiennent un matériau de conversion.

5. Module optoélectronique selon l'une des revendications 1 à 3, dans lequel le matériau isolant (3) et/ou la couche isolante (4) sont transparents.

6. Module optoélectronique selon l'une des revendications précédentes, dans lequel le matériau isolant (3) résiste aux UV.

7. Module optoélectronique selon l'une des revendications précédentes, dans lequel les parties (21, 22) de raccordement électrique sont toutes deux situées dans une partie latérale des côtés (2a) de sortie de rayonnement et les parties (21, 22) de raccordement électrique sont reliées l'une à l'autre sur les côtés respectifs (2a) de sortie de rayonnement, les parties (21, 22) de raccordement électrique étant configurées en encadrement de telle sorte que lorsque les corps semi-conducteurs (2) sont en fonctionnement, les parties (21, 22) de raccordement électrique permettent une propagation du courant.

8. Module optoélectronique selon l'une des revendications précédentes, dans lequel les côtés (2a) de sortie de rayonnement ne présentent pas de couche isolante (4) au moins au niveau de la sortie du rayonnement.

9. Module optoélectronique selon l'une des revendications précédentes, dans lequel la couche isolante (4) est un film multifonctionnel et remplit au moins une autre fonction sélectionnée parmi la protection contre les effets de l'environnement, la protection contre les UV, la protection contre l'absorption d'eau, la protection contre les dégradations, la protection contre les effets de la température et/ou la protection contre la formation de fissures.

10. Procédé de fabrication d'un module optoélectronique selon l'une des revendications précédentes, le procédé présentant les étapes suivantes :
A) placement d'un premier corps semi-conducteur (2) sur un support (1) par son côté non tourné vers le côté (2a) de sortie de rayonnement,
B) placement d'un matériau isolant (3) latéralement à côté du premier corps semi-conducteur (2) sur le support (1), le matériau isolant (3) étant configuré en biseau et s'adaptant en correspondance géométrique au corps semi-conducteur (2),
C) ensuite, application d'une couche isolante (4) sur certaines parties du corps semi-conducteur (2) et du matériau isolant (3),
D) ensuite, application d'au moins une structure conductrice plane sur la couche isolante (4) pour assurer le contact électrique du corps semi-conducteur (2),
à l'étape de traitement A), le deuxième corps semi-conducteur (2) étant disposé à côté du premier corps semi-conducteur (2) sur le support (1) et
à l'étape de traitement B), dans les zones situées entre les corps semi-conducteurs (2), le matériau isolant (3) est placé en correspondance géométrique sur les corps semi-conducteurs (2) et le matériau isolant (3) adjacent aux côtés extérieurs du premier corps semi-conducteur (2) et du deuxième corps semi-conducteur (2) est configuré en biseau et est adjacent en correspondance géométrique aux corps semi-conducteurs (2),
de telle sorte que les parties situées entre les corps semi-conducteurs soient planées au moyen du matériau isolant, de telle sorte que dans ces parties situées entre les corps semi-conducteurs, la hauteur du matériau isolant corresponde à la hauteur de chaque corps semi-conducteur et que la hauteur maximale du matériau isolant configuré en biseau corresponde à la hauteur de ces corps semi-conducteurs sur les surfaces latérales extérieures du premier et du deuxième corps semi-conducteur,
de telle sorte que lors de l'application d'une technique photographique qui suit l'étape D), une opération d'éclairage soit permise par le fait que la formation de flancs accusés de la couche isolante (4) est évitée.

11. Procédé selon la revendication 10, dans lequel à l'étape de traitement A), plusieurs autres corps semi-conducteurs (2) sont disposés entre le premier corps semi-conducteur (2) et le deuxième corps semi-conducteur (2), le matériau isolant (3) étant configuré en correspondance géométrique aux corps semi-conducteurs (2) dans les zones situées entre des corps semi-conducteurs (2) voisins.

12. Procédé selon l'une des revendications 10 ou 11 qui précèdent, dans lequel l'étape de traitement B) et/ou l'étape de traitement C) comportent une opération au pochoir ou de sérigraphie.

13. Procédé selon l'une des revendications 10 à 12 qui précèdent, dans lequel l'étape de traitement C) comporte une opération de stratification.

14. Procédé selon l'une des revendications 10 à 12 qui précèdent, dans lequel l'étape de traitement C) comporte une opération de distribution ou de projection.
